# EUROPEAN PATENT APPLICATION

(11) **EP 3 048 865 A1**
(43) Date of publication of application: **27.07.2016**
(21) Application number: 14840229.0
(22) Date of filing: 04.03.2014
(51) Int. Cl.: H05K 5/00

(54) **CABINET**

(30) Priority: 27.08.2013 CN 201310378714
(71) Applicant: Huawei Technologies Co., Ltd., Longgang District Shenzhen, Guangdong 518129 (CN)
(72) Inventor: GUO, Haihui, Shenzhen Guangdong 518129 (CN)
(74) Representative: Körber, Martin Hans
(86) International application number: PCT/CN2014/072838
(87) International publication number: WO 2015/027697

(57) **Abstract**

The present invention discloses a cabinet (100), including a first beam (10), a second beam (20), a cover plate (30), a bottom plate (40), an enclosure frame (50), and a door frame (60), where the first beam (10) is provided with a first groove (12) and a second groove (14); the second beam (20) is provided with a first slot (22) and a second slot (24); the door frame (60) is provided with a first fixing groove (62); the cover plate (30) is inserted into the first groove (12); the bottom plate (40) is inserted into the first slot (22); one end portion of the enclosure frame (50) is accommodated in the second groove (14), and the other end portion of the enclosure frame (50) is accommodated in the second slot (24); and a front end of the cover plate (30), a front end of the bottom plate (40), and a front end of the enclosure frame (50) are all inserted into the first fixing groove (62), so that the first beam (10), the second beam (20), the cover plate (30), the bottom plate (40), the enclosure frame (50), and the door frame (60) are assembled into the cabinet (100). According to the cabinet (100) provided in the present invention, the first beam (10), the second beam (20), the cover plate (30), the bottom plate (40), the door frame (60), and the enclosure frame (50) can be assembled into the cabinet (100) by using the first groove (12) and the second groove (14) of the first beam (10), the first slot (22) and the second slot (24) of the second beam (20), and the first fixing groove (62) of the door frame (60), thereby resolving a problem of heavy workload caused by overall welding of a cabinet in the prior art.

## Description

This application claims priority to Chinese Patent Application No. 201310378714.1, filed with the Chinese Patent Office on August 27, 2013, and entitled "CABINET", which is incorporated herein by reference in its entirety.

### TECHNICAL FIELD

The present invention relates to the field of communications technologies, and in particular, to a cabinet.

### BACKGROUND

An existing cabinet generally includes an enclosure frame, a bottom plate, a top cover, and a front door. The enclosure frame, the bottom plate, and the top cover are connected to form a closed quadrilateral frame structure that is used for installing electronic devices such as a base station device, a power supply device, a temperature control device, and a transmission device. However, generally, the enclosure frame, the bottom plate, and the top cover of the existing cabinet are fixedly connected by means of welding. In this manner of fixing a cabinet by means of overall welding, the cabinet not only requires a heavy welding and polishing workload, but also easily deforms, is difficult to transport, and occupies large space for storage, thereby causing low processing efficiency and high costs. Especially, for a large-size cabinet, it is more difficult to perform welding and polishing, thereby further increasing costs.

### SUMMARY

A technical problem to be resolved by the present invention is to resolve a problem of high cabinet installation costs in the prior art.

To achieve the foregoing objective, implementation manners of the present invention provide the following technical solutions:
According to one aspect, a cabinet is provided, where the cabinet includes a first beam, a second beam, a cover plate, a bottom plate, an enclosure frame, and a door frame, where the first beam is provided with a first groove and a second groove; the second beam is provided with a first slot and a second slot; the door frame is provided with a first fixing groove; the cover plate is inserted into the first groove; the bottom plate is inserted into the first slot; one end portion of the enclosure frame is accommodated in the second groove, and the other end portion of the enclosure frame is accommodated in the second slot; and a front end of the cover plate, a front end of the bottom plate, and a front end of the enclosure frame are all inserted into the first fixing groove, so that the first beam, the second beam, the cover plate, the bottom plate, the enclosure frame, and the door frame are assembled into the cabinet.

In a first possible implementation manner, the first groove, the second groove, the first slot, the second slot, and the first fixing groove are all in a U-shape.

With reference to the first possible implementation manner, in a second possible implementation manner, an inner surface of the first groove, an inner surface of the second groove, an inner surface of the first slot, an inner surface of the second slot, and an inner surface of the first fixing groove are all serrated.

In a third possible implementation manner, the first beam is further provided with a third groove and the second beam is further provided with a third slot, for installing an internal plug-in unit of the cabinet.

With reference to the third possible implementation manner, in a fourth possible implementation manner, both the third groove and the third slot are in a C-shape.

With reference to the fourth possible implementation manner, in a fifth possible implementation manner, both an inner surface of the third groove and an inner surface of the third slot are serrated.

In a sixth possible implementation manner, the door frame is further provided with a second fixing groove, for installing an internal plug-in unit of the cabinet.

With reference to the sixth possible implementation manner, in a seventh possible implementation manner, the second fixing groove is in a C-shape.

With reference to the seventh possible implementation manner, in an eighth possible implementation manner, an inner surface of the second fixing groove is serrated.

According to another aspect, a cabinet is provided, where the cabinet includes a first beam, a second beam, at least one third beam, a cover plate, a bottom plate, a first enclosure frame, a second enclosure frame, and a door frame, where the first beam is provided with a first groove and a second groove; the second beam is provided with a first slot and a second slot; the third beam is provided with a first accommodating groove and a second accommodating groove; the door frame is provided with a first fixing groove; the cover plate is inserted into the first groove; the bottom plate is inserted into the first slot; one end portion of the first enclosure frame is accommodated in the second groove, and the other end portion of the first enclosure frame is accommodated in the first accommodating groove; one end portion of the second enclosure frame is accommodated in the second slot, and the other end portion of the second enclosure frame is accommodated in the second accommodating groove; and a front end of the cover plate, a front end of the bottom plate, and front ends of the first enclosure frame and the second enclosure frame are all inserted into the first fixing groove, so that the first beam, the second beam, the third beam, the cover plate, the bottom plate, the first enclosure frame, the second enclosure frame, and the door frame are assembled into the cabinet.

In a first possible implementation manner, the first groove, the second groove, the first slot, the second slot, and the first fixing groove are all in a U-shape.

With reference to the first possible implementation manner, in a second possible implementation manner, an inner surface of the first groove, an inner surface of the second groove, an inner surface of the first slot, an inner surface of the second slot, and an inner surface of the first fixing groove are all serrated.

In a third possible implementation manner, the first beam is further provided with a third groove and the second beam is further provided with a third slot, for installing an internal plug-in unit of the cabinet.

With reference to the third possible implementation manner, in a fourth possible implementation manner, both the third groove and the third slot are in a C-shape.

With reference to the fourth possible implementation manner, in a fifth possible implementation manner, both an inner surface of the third groove and an inner surface of the third slot are serrated.

In a sixth possible implementation manner, the door frame is further provided with a second fixing groove, for installing an internal plug-in unit of the cabinet.

With reference to the sixth possible implementation manner, in a seventh possible implementation manner, the second fixing groove is in a C-shape.

With reference to the seventh possible implementation manner, in an eighth possible implementation manner, an inner surface of the second fixing groove is serrated.

In a ninth possible implementation manner, the third beam is further provided with a third accommodating groove, for installing an internal plug-in unit of the cabinet.

With reference to the ninth possible implementation manner, in a tenth possible implementation manner, the third accommodating groove is in a C-shape, and an inner surface of the third accommodating groove is serrated.

According to the cabinet provided in the present invention, a first beam, a second beam, a cover plate, a bottom plate, a door frame, and an enclosure frame can be assembled into the cabinet by using a first groove and a second groove of the first beam, a first slot and a second slot of the second beam, and a first fixing groove of the door frame, thereby resolving a problem of heavy workload caused by overall welding of a cabinet in the prior art.

### BRIEF DESCRIPTION OF DRAWINGS

To describe the technical solutions in the embodiments of the present invention more clearly, the following briefly introduces the accompanying drawings required for describing the embodiments. Apparently, the accompanying drawings in the following description show merely some embodiments of the present invention, and a person of ordinary skill in the art may still derive other drawings from these accompanying drawings without creative efforts.
FIG. 1 is a schematic exploded view of a cabinet according to a first implementation manner of the present invention;
FIG. 2 is a schematic sectional view of a first beam shown in FIG. 1;
FIG. 3 is a schematic sectional view of a second beam shown in FIG. 1;
FIG. 4 is a schematic sectional view of a door frame shown in FIG. 1;
FIG. 5 is a schematic assembly diagram of the cabinet shown in FIG. 1;
FIG. 6 is an enlarged schematic diagram of a circular VI in FIG. 5;
FIG. 7 is a schematic exploded view of a cabinet according to a second implementation manner of the present invention; and
FIG. 8 is a schematic sectional view of a third beam shown in FIG. 7.

### DESCRIPTION OF EMBODIMENTS

The following clearly and completely describes the technical solutions in the embodiments of the present invention with reference to the accompanying drawings in the embodiments of the present invention. Apparently, the described embodiments are merely some but not all of the embodiments of the present invention. All other embodiments obtained by a person of ordinary skill in the art based on the embodiments of the present invention without creative efforts shall fall within the protection scope of the present invention.

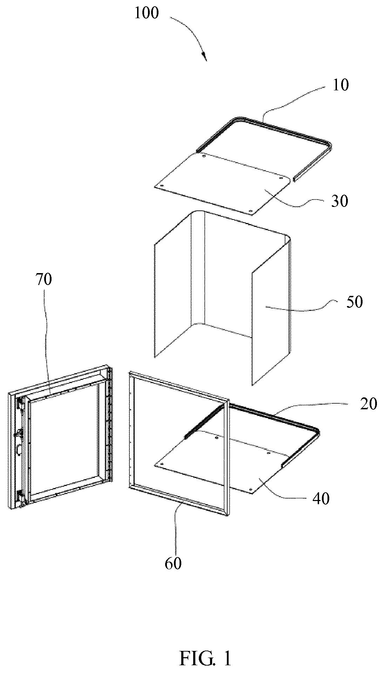

Refer to FIG. 1, which is a cabinet 100 according to a first implementation manner of the present invention. The cabinet 100 includes a first beam 10, a second beam 20, a cover plate 30, a bottom plate 40, an enclosure frame 50, and a door frame 60.

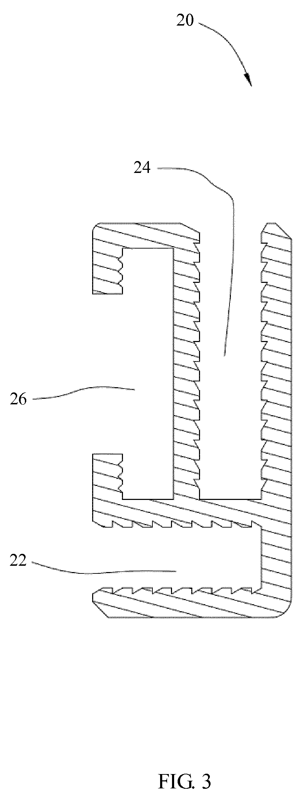

Referring to FIG. 1 to FIG. 5, the first beam 10 is provided with a first groove 12 and a second groove 14; the second beam 20 is provided with a first slot 22 and a second slot 24; and the door frame 60 is provided with a first fixing groove 62. During installation, the cover plate 30 is inserted into the first groove 12; the bottom plate 40 is inserted into the first slot 22; one end portion of the enclosure frame 50 is accommodated in the second groove 14, and the other end portion of the enclosure frame 50 is accommodated in the second slot 24; and a front end of the cover plate 30, a front end of the bottom plate 40, and a front end of the enclosure frame 50 are all inserted into the first fixing groove 62, so that the first beam 10, the second beam 20, the cover plate 30, the bottom plate 40, the enclosure frame 50, and the door frame 60 are assembled into the cabinet 100.

According to the cabinet 100 in the present invention, a first beam 10, a second beam 20, a cover plate 30, a bottom plate 40, a door frame 60, and an enclosure frame 50 can be assembled into the cabinet 100 by using a first groove 12 and a second groove 14 of the first beam 10, a first slot 22 and a second slot 24 of the second beam 20, and a first fixing groove 62 of the door frame 60, thereby resolving a problem of heavy workload caused by overall welding of a cabinet in the prior art.

In this implementation manner, a structure of the first beam 10 is the same as a structure of the second beam 20. In another implementation manner, the structure of the first beam 10 may also be different from the structure of the second beam 20.

In this implementation manner, structures of the cover plate 30 and the bottom plate 40 are the same. In another implementation manner, the structures of the cover plate 30 and the bottom plate 40 may also be different.

In this implementation manner, the cover plate 30 and the bottom plate 40 may be steel plates, aluminum plates, stainless steel plates, aluminum-composite plates, or the like. That is, for the cabinet 100 in the present invention, materials of the cover plate 30 and the bottom plate 40 may be changed at will according to needs.

Further, the first beam 10 and the second beam 20 are in a U-shape. In addition, a section of the enclosure frame 50 is also in a U-shape. During installation, an end portion of the enclosure frame 50 is easily inserted into the second groove 14 of the first beam 10 or the second slot 24 of the second beam 20, so that the first beam 10, the second beam 20, and the enclosure frame 50 can be conveniently installed as a whole. That is, for the cabinet 100 in the present invention, the first beam 10 and the second beam 20 are in a U-shape, the section of the enclosure frame 50 is in a U-shape, and therefore, the first beam 10, the second beam 20, and the enclosure frame 50 can be easily installed as a whole.

In this implementation manner, the enclosure frame 50 may be a steel plate, an aluminum plate, a stainless steel plate, an aluminum-composite plate, or the like. That is, for the cabinet 100 in the present invention, a material of the enclosure frame 50 may be changed at will according to needs.

In this implementation manner, the first groove 12, the second groove 14, the first slot 22, the second slot 24, and the first fixing groove 62 are all in a U-shape.

As a further improvement of the present invention, an inner surface of the first groove 12, an inner surface of the second groove 14, an inner surface of the first slot 22, an inner surface of the second slot 24, and an inner surface of the first fixing groove 62 are all serrated. During installation, the cover plate 30 is inserted into the first groove 12 along the serrated shape; the bottom plate 40 is inserted into the first slot 22 along the serrated shape; the one end portion of the enclosure frame 50 is accommodated in the second groove 14 along the serrated shape, and the other end portion of the enclosure frame 50 is accommodated in the second slot 24 along the serrated shape; and the front end of the cover plate 30, the front end of the bottom plate 40, and the front end of the enclosure frame 50 are all inserted into the first fixing groove 62 along the serrated shape, so that the first beam 10, the second beam 20, the cover plate 30, the bottom plate 40, the enclosure frame 50, and the door frame 60 are easily assembled into the cabinet 100.

The inner surface of the first groove 12, the inner surface of the second groove 14, the inner surface of the first slot 22, the inner surface of the second slot 24, and the inner surface of the first fixing groove 62 are all serrated. Therefore, during disassembly, the cover plate 30 needs to be removed from the first groove 12 against the serrated shape; the bottom plate 40 needs to be removed from the first slot 22 against the serrated shape; the one end portion of the enclosure frame 50 needs to be removed from the second groove 14 against the serrated shape, and the other end portion of the enclosure frame 50 needs to be removed from the second slot 24 against the serrated shape; and the front end of the cover plate 30, the front end of the bottom plate 40, and the front end of the enclosure frame 50 all need to be removed from the first fixing groove 62 against the serrated shape, so that the cover plate 30 cannot be easily detached from the first beam 10 and the door frame 60, the bottom plate 40 cannot be easily detached from the second beam 20 and the door frame 60, and the enclosure frame 50 cannot be easily detached from the first beam 10, the second beam 20, and the door frame 60, thereby further improving firmness of the first beam 10, the second beam 20, the door frame 60, the cover plate 30, the bottom plate 40, and the enclosure frame 50.

In another implementation manner, the inner surface of the first groove 12, the inner surface of the second groove 14, the inner surface of the first slot 22, the inner surface of the second slot 24, and the inner surface of the first fixing groove 62 may also not be serrated.

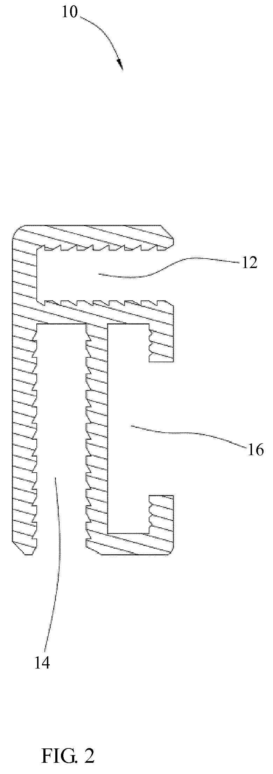

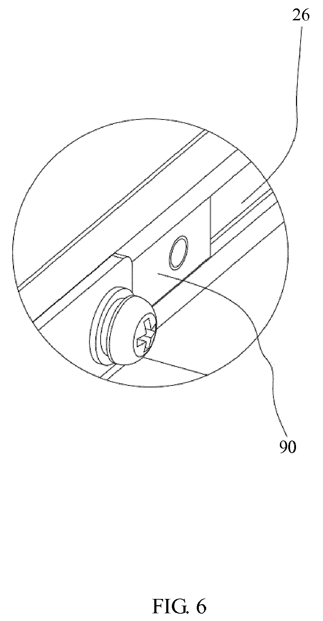

As shown in FIG. 2, FIG. 3, FIG. 5, and FIG. 6, as a further improvement of the present invention, the first beam 10 is further provided with a third groove 16 and the second beam 20 is further provided with a third slot 26, for installing an internal plug-in unit 90 of the cabinet 100.

In this implementation manner, the internal plug-in unit 90 of the cabinet 100 is a mounting plate that can be inserted into the third groove 16 or the third slot 26. The mounting plate is provided with multiple threaded holes. Other components, such as a base station device, a power supply device, a temperature control device, and a transmission device, that need to be installed in the cabinet 100 may be fixed inside the cabinet 100 by means of locking screws. In addition, a quantity of mounting plates may be changed according to needs.

In another implementation manner, the other components, such as a base station device, a power supply device, a temperature control device, and a transmission device, in the cabinet 100 are installed on the internal plug-in unit 90 by using a conversion bracket 91, that is, the conversion bracket 91 is first installed on the internal plug-in unit 90, and then the base station device, the power supply device, the temperature control device, and the transmission device are installed on the conversion bracket 91. That is, the base station device, the power supply device, the temperature control device, and the transmission device are not directly installed on the internal plug-in unit 90.

In this implementation manner, both the third groove 16 and the third slot 26 are in a C-shape.

As a further improvement of the present invention, both an inner surface of the third groove 16 and an inner surface of the third slot 26 are serrated, which increases friction between the mounting plate and the third groove 16 or between the mounting plate and the third slot 26, and therefore can prevent the mounting plate from swaying in the third groove 16 or the third slot 26.

In another implementation manner, the inner surface of the third groove 16 and the inner surface of the third slot 26 may also not be serrated.

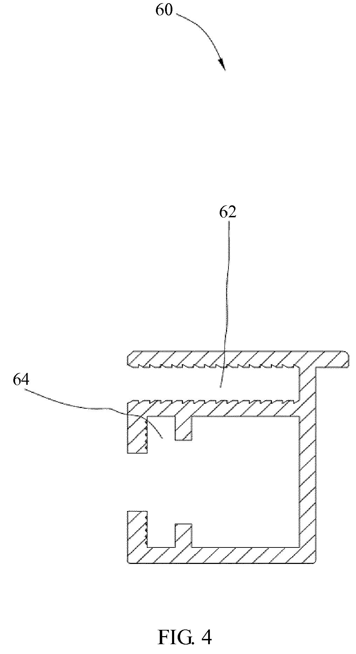

As shown in FIG. 4, as a further improvement of the present invention, the door frame 60 is further provided with a second fixing groove 64, for installing an internal plug-in unit of the cabinet 100.

In this implementation manner, an internal plug-in unit installed in the second fixing groove 64 is an interface nut strip.

In this implementation manner, the second fixing groove 64 is in a C-shape, and an inner surface of the second fixing groove 64 is serrated.

In another implementation manner, the inner surface of the second fixing groove 64 may also not be serrated.

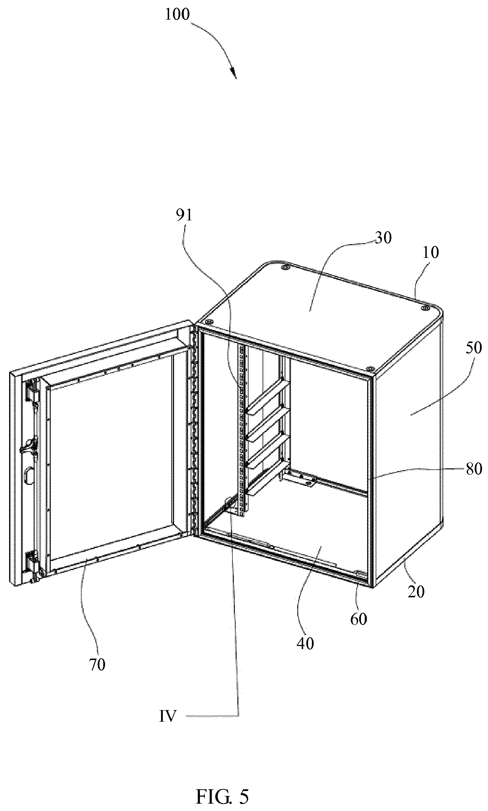

As shown in FIG. 5, as a further improvement of the present invention, the cabinet 100 further includes a door 70 and a waterproof rubber strip 80. The door 70 is installed in the door frame 60. The waterproof rubber strip 80 is installed along the door frame 60 or the door 70 to seal the door 70 and the door frame 60, so as to prevent rainwater from entering the cabinet 100.

In another implementation manner, there may also be no waterproof rubber strip 80 between the door 70 and the door frame 60.

As shown in FIG. 1 to FIG. 6, during installation, the cover plate 30 is inserted into the first groove 12 of the first beam 10; the bottom plate 40 is inserted into the first slot 22 of the second beam 20; the one end portion of the enclosure frame 50 is accommodated in the second slot 14 of the first beam 10, and the other end portion of the enclosure frame 50 is accommodated in the second slot 24 of the second beam 20; the front end of the cover plate 30, the front end of the bottom plate 40, and the front end of the enclosure frame 50 are all inserted into the first fixing groove 62 of the door frame 60; and then the door 70 is installed in the door frame 60, so that the first beam 10, the second beam 20, the cover plate 30, the bottom plate 40, the enclosure frame 50, the door frame 60, and the door 70 are assembled into the cabinet 100.

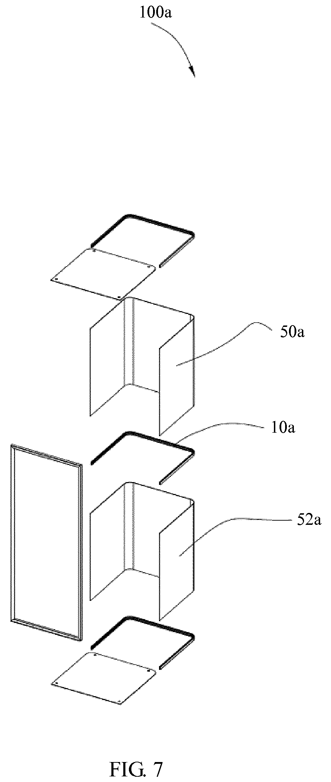

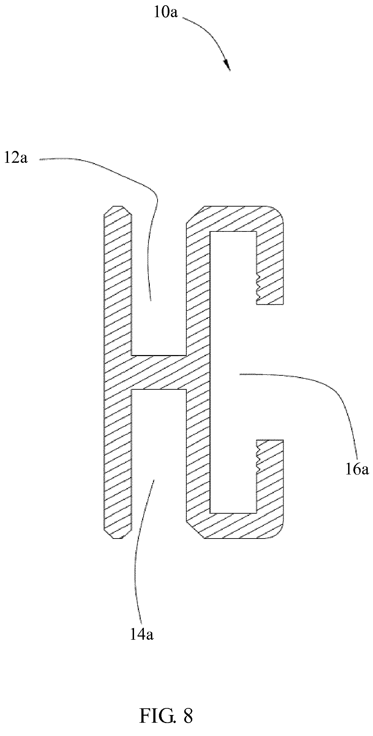

Referring to FIG. 7 and FIG. 8, a second implementation manner of the present invention provides a cabinet 100a. The cabinet 100a provided in the second implementation manner and the cabinet 100 (referring to FIG. 1) provided in the first implementation manner have basically same structures and implement similar functions. A difference between the cabinet 100a and the cabinet 100 lies in that the cabinet 100a further includes at least one third beam 10a, a first enclosure frame 50a, and a second enclosure frame 52a, where the third beam 10a is provided with a first accommodating groove 12a and a second accommodating groove 14a. During installation, one end portion of the first enclosure frame 50a is inserted into the first accommodating groove 12a, and one end portion of the second enclosure frame 52a is inserted into the second accommodating groove 14a, that is, the first enclosure frame 50a and the second enclosure 52a are assembled as a whole by using the third beam 10a, thereby increasing a volume of the cabinet 100a.

According to the cabinet 100 in the present invention, a first enclosure frame 50a and a second enclosure frame 52a may be connected by using a third beam 10a, that is, a volume of the cabinet 100a may be expanded by using one third beam 10a and the first enclosure frame 50a or the second enclosure frame 52a, so that the volume of the cabinet 100a in the present invention can be easily expanded. If the volume of the cabinet 100a needs to be further expanded, only one third beam 10a and one third enclosure frame need to be added. That is, for the cabinet 100a in the present invention, the volume of the cabinet 100a can be easily increased by adding a third beam 10a and increasing a quantity of enclosure frames, so that the volume of the cabinet 100a is not restricted by a size of a sheet material, which improves a degree of modularity of the cabinet 100a, and can quickly meet differential demands of different customers.

In this implementation manner, heights of the first enclosure frame 50a and the second enclosure frame 52a may be the same or may be different.

As a further improvement of the present invention, the third beam 10a is further provided with a third accommodating groove 16a, for installing an internal plug-in unit of the cabinet 100a.

In this implementation manner, the third accommodating groove 16a is in a C-shape, and an inner surface of the third accommodating groove 16a is serrated.

In another implementation manner, the inner surface of the third accommodating groove 16a may also not be serrated.

The foregoing implementation manners are not intended to limit the protection scope of the technical solutions. Any modification, equivalent replacement, and improvement made without departing from the spirit and principle of the foregoing implementation manners shall fall within the protection scope of the technical solutions.

## Claims

1. A cabinet, wherein the cabinet comprises a first beam, a second beam, a cover plate, a bottom plate, an enclosure frame, and a door frame, wherein the first beam is provided with a first groove and a second groove; the second beam is provided with a first slot and a second slot; the door frame is provided with a first fixing groove; the cover plate is inserted into the first groove; the bottom plate is inserted into the first slot; one end portion of the enclosure frame is accommodated in the second groove, and the other end portion of the enclosure frame is accommodated in the second slot; and a front end of the cover plate, a front end of the bottom plate, and a front end of the enclosure frame are all inserted into the first fixing groove, so that the first beam, the second beam, the cover plate, the bottom plate, the enclosure frame, and the door frame are assembled into the cabinet.

2. The cabinet according to claim 1, wherein the first groove, the second groove, the first slot, the second slot, and the first fixing groove are all in a U-shape.

3. The cabinet according to claim 2, wherein an inner surface of the first groove, an inner surface of the second groove, an inner surface of the first slot, an inner surface of the second slot, and an inner surface of the first fixing groove are all serrated.

4. The cabinet according to claim 1, wherein the first beam is further provided with a third groove and the second beam is further provided with a third slot, for installing an internal plug-in unit of the cabinet.

5. The cabinet according to claim 4, wherein both the third groove and the third slot are in a C-shape.

6. The cabinet according to claim 5, wherein both an inner surface of the third groove and an inner surface of the third slot are serrated.

7. The cabinet according to claim 1, wherein the door frame is further provided with a second fixing groove, for installing an internal plug-in unit of the cabinet.

8. The cabinet according to claim 7, wherein the second fixing groove is in a C-shape.

9. The cabinet according to claim 8, wherein an inner surface of the second fixing groove is serrated.

10. A cabinet, wherein the cabinet comprises a first beam, a second beam, at least one third beam, a cover plate, a bottom plate, a first enclosure frame, a second enclosure frame, and a door frame, wherein the first beam is provided with a first groove and a second groove; the second beam is provided with a first slot and a second slot; the third beam is provided with a first accommodating groove and a second accommodating groove; the door frame is provided with a first fixing groove; the cover plate is inserted into the first groove; the bottom plate is inserted into the first slot; one end portion of the first enclosure frame is accommodated in the second groove, and the other end portion of the first enclosure frame is accommodated in the first accommodating groove; one end portion of the second enclosure frame is accommodated in the second slot, and the other end portion of the second enclosure frame is accommodated in the second accommodating groove; and a front end of the cover plate, a front end of the bottom plate, and front ends of the first enclosure frame and the second enclosure frame are all inserted into the first fixing groove, so that the first beam, the second beam, the third beam, the cover plate, the bottom plate, the first enclosure frame, the second enclosure frame, and the door frame are assembled into the cabinet.

11. The cabinet according to claim 10, wherein the first groove, the second groove, the first slot, the second slot, and the first fixing groove are all in a U-shape.

12. The cabinet according to claim 11, wherein an inner surface of the first groove, an inner surface of the second groove, an inner surface of the first slot, an inner surface of the second slot, and an inner surface of the first fixing groove are all serrated.

13. The cabinet according to claim 10, wherein the first beam is further provided with a third groove and the second beam is further provided with a third slot, for installing an internal plug-in unit of the cabinet.

14. The cabinet according to claim 13, wherein both the third groove and the third slot are in a C-shape.

15. The cabinet according to claim 14, wherein both an inner surface of the third groove and an inner surface of the third slot are serrated.

16. The cabinet according to claim 10, wherein the door frame is further provided with a second fixing groove, for installing an internal plug-in unit of the cabinet.

17. The cabinet according to claim 16, wherein the second fixing groove is in a C-shape.

18. The cabinet according to claim 17, wherein an inner surface of the second fixing groove is serrated.

19. The cabinet according to claim 10, wherein the third beam is further provided with a third accommodating groove, for installing an internal plug-in unit of the cabinet.

20. The cabinet according to claim 19, wherein the third accommodating groove is in a C-shape, and an inner surface of the third accommodating groove is serrated.
